# EUROPÄISCHE PATENTSCHRIFT

(11) **EP 3 905 298 B1**
(45) Veröffentlichungstag und Bekanntmachung des Hinweises auf die Patenterteilung: **29.05.2024**
(21) Anmeldenummer: 20172379.8
(22) Anmeldetag: 30.04.2020
(51) Int. Cl.: H01H 71/74, H01H 89/06, H02H 7/08, H02P 1/02, H03K 17/00

(54) **KOMMUNIKATIONSMODUL**
COMMUNICATION MODULE
MODULE DE COMMUNICATION

(43) Veröffentlichungstag der Anmeldung: 03.11.2021
(73) Patentinhaber: Siemens Aktiengesellschaft, 80333 München (DE)
(72) Erfinder: Seitz, Johann, 92224 Amberg (DE); Pachmann, Sandro, 92278 Illschwang (DE)
(74) Vertreter: Siemens Patent Attorneys

(56) Entgegenhaltungen:
- DE-A1-102004 051 835
- US-A1- 2005 200 326
- US-A1- 2006 208 673
- US-A1- 2009 326 900
- US-A1- 2017 186 566

## Beschreibung

Die Erfindung betrifft eine Kombination von einem Schaltgerät und einem Kommunikationsmodul, sowie ein Verfahren zur Umstellung der Parametrierung eines Schaltgeräts auf Fernparametrierung.

Verschiedene parametrierbare Schaltgeräte wie elektronische Motorstarter, Funktionsrelais, usw. verfügen über Einstellelemente, z. B. mit einem Potentiometer, einem Drehcodierschalter oder einem Drehwahlschalter, mit denen Parameter von einem Anwender direkt am Gerät vorgegeben werden können. Zum Beispiel weist der von der Siemens AG produzierte Sanftstarter SIRIUS 3RW50 Einstellelemente zur manuellen Einstellung der Parameter Startspannung, Anlauframpenzeit, Strombegrenzungswert, Bemessungsbetriebsstrom des Motors, CLASS-Einstellung für den Motorüberlastschutz (engl.: Motor Overload Trip Classes, z. B. 10A, 10E, 20E) und Auslaufzeit mithilfe eines Schraubendrehers auf. Bei solchen Schaltgeräten ist der eingestellte Parameterwert an einer Skalenanzeige der Einstellelemente ablesbar.

Wird ein solches Schaltgerät über ein zusätzliches Kommunikationsmodul in ein Kommunikationsnetz eingebunden oder mit einer zusätzlichen Eingabeeinheit, z. B. ein HMI, ausgestattet, kann das Schaltgerät über das Kommunikationsnetz oder die zusätzliche Eingabeeinheit auch aus der Ferne parametriert werden, was im Folgenden auch als Fernparametrierung bezeichnet wird (HMI = Human Machine Interface). Beispielsweise stehen 3RW5 Kommunikationsmodule zur Einbindung der Siemens Sanftstarter SIRIUS 3RW5 in Feldbussysteme wie Profinet, Profibus, Ethernet/IP, Modbus RTU oder Modbus TCP zur Verfügung.

Somit kann sich ein Gegensatz ergeben zwischen Parametern, die unmittelbar am Gerät einstellbar sind, und Parametern, die durch Fernparametrierung einstellbar sind: es kann das Problem auftreten, dass an den Skalenanzeigen der Einstellelemente andere Parameterwerte angezeigt werden als geräteintern, über die Fernparametrierung vorgegeben, tatsächlich verwendet werden. Für den Anwender ergibt sich dadurch ein nicht eindeutiger Zustand oder der Anwender geht von falschen Einstellwerten aus.

Dieses Problem wurde bisher z. B. dadurch gelöst, dass bei Schaltgeräten darauf verzichtet wurde, die Parametrierung der über Einstellelemente einstellbaren Parameter alternativ durch Fernparametrierung vornehmen zu können. Daraus kann sich aber eine eingeschränkte Parametrierung ergeben. Der Ausschluss der Fernparametrierung die Genauigkeit der Parametrierung begrenzen, da die über Einstellelemente unmittelbar am Gerät einstellbaren Parameter eine höhere Ungenauigkeit aufweisen können als die aus der Ferne einstellbaren Parameter. Mit Einstellelementen ist die Reproduzierbarkeit von Einstellwerten nur dann mit einer definierten Genauigkeit möglich, wenn die Einstellelemente aufwändig abgeglichen werden.

Eine andere Möglichkeit zur Lösung des Problems besteht darin, dass man die Art der Parametrierung durch eine Einstellungsoption auswählen kann, was jedoch für den Anwender dazu führen kann, dass er versehentlich davon ausgeht, dass die an den Einstellelementen eingestellten Werte der Parameter wirksam sind, obwohl durch Fernparametrierung eingestellte Werte im Gerät verwendet werden.

Der Erfindung liegt daher die Aufgabe zugrunde, die Parametrierung eines parametrierbaren Schaltgeräts zu verbessern.

Die Aufgabe wird gelöst durch eine Kombination gemäß Anspruch 1. Das Kommunikationsmodul ist eine für eine Funktionserweiterung des Schaltgeräts in Bezug auf Kommunikation erforderliche Baugruppe. Das Kommunikationsmodul ist geeignet zur lösbaren Befestigung an einem parametrierbaren Schaltgerät, so dass es eine definierte Position relativ zum Schaltgerät einnimmt. Dazu weist das Kommunikationsmodul ein oder mehrere Befestigungselemente zur positionstreuen Befestigung des Kommunikationsmoduls am Schaltgerät auf, die somit als Positioniermittel fungieren. Positionstreu bedeutet, dass das Kommunikationsmodul mithilfe der Befestigungselemente in einer definierten Position am Schaltgerät befestigt werden kann. Ein parametrierbares Schaltgerät ist ein Schaltgerät, z. B. ein Schütz, ein Relais, oder ein Motorstarter, dem Parameter zu seinem Betrieb vorgegeben werden können. Dazu weist das Schaltgerät ein oder mehrere, an einer Bedienseite des Schaltgeräts angeordnete Einstellelemente zum Einstellen je eines Parameterwerts für die einzelnen Parameter auf. Als Einstellelement kann z. B. ein Drehknopf dienen, der eine Markierung trägt, die von einem Anwender auf einen beliebigen Wert einer Skalenanzeige eingestellt werden kann. Dabei ist das Einstellelement über eine Wirkverbindung mit einem Potentiometer oder einem Drehcodierschalter verbunden, die als Bauelement einer elektrischen Schaltung einen entsprechenden Parameterwert, der im Betrieb des Schaltgeräts Verwendung finden soll, definieren. Dabei ist die für das Kommunikationsmodul definierte Position relativ zum Schaltgerät derart, dass Gehäuseteile des Kommunikationsmoduls eines oder mehrere der Einstellelemente des Schaltgeräts abdecken, wenn das Kommunikationsmodul am Schaltgerät befestigt ist. Die abgedeckten Einstellelemente können somit von einem Anwender nicht mehr eingestellt und nicht mehr abgelesen werden.

Gemäß der Erfindung weist das Kommunikationsmodul ein oder mehrere Befestigungselemente auf, mit denen das Kommunikationsmodul in einer vorgegebenen Position relativ zum Schaltgerät, d. h. positionstreu, befestigt werden kann. Das Kommunikationsmodul kann ein oder mehrere Rastnasen aufweisen, die mit korrespondierenden Rastaufnahmen im Schaltgerät zusammenwirken. Das Kommunikationsmodul kann auch ein oder mehrere Rastaufnahmen aufweisen, die mit korrespondierenden Rastnasen im Schaltgerät zusammenwirken. Es sind auch alle sonstigen lösbaren Befestigungsvorrichtungen wie Schrauben, Stifte, Einhängevorrichtungen, magnetische Verbindungen, etc. möglich, mit denen das Kommunikationsmodul am Schaltgerät befestigt werden kann.

Das Schaltgerät ist parametrierbar und weist dazu ein oder mehrere Einstellelemente zum Einstellen von Parameterwerten des Schaltgeräts auf. Das Schaltgerät ist außerdem so ausgestaltet, dass es mit einem Kommunikationsmodul zusammenwirkt, d. h. eine definierte Position für die Befestigung des Kommunikationsmoduls am Schaltgerät bereithält. Dazu weist das Schaltgerät ein oder mehrere Befestigungselemente zur positionstreuen Befestigung eines Kommunikationsmoduls am Schaltgerät auf, derart, dass eines oder mehrere der Einstellelemente des Schaltgeräts durch das Kommunikationsmodul abgedeckt werden.

Gemäß der Erfindung weist das Schaltgerät ein oder mehrere Befestigungselemente auf, die zum Befestigen des Kommunikationsmoduls in einer vorgegebenen Position relativ zum Schaltgerät, d. h. positionstreu, dienen, und die somit als Positioniermittel fungieren. Dabei korrespondieren die Befestigungselemente des Schaltgeräts mit den am Kommunikationsmodul angeordneten Befestigungselementen. Zum Beispiel kann das Kommunikationsmodul ein oder mehrere Rastnasen aufweisen, die mit korrespondierenden Rastaufnahmen im Schaltgerät zusammenwirken. Oder das Kommunikationsmodul kann auch ein oder mehrere Rastaufnahmen aufweisen, die mit korrespondierenden Rastnasen im Schaltgerät zusammenwirken.

Und die Aufgabe wird außerdem gelöst durch ein Verfahren gemäß Anspruch 5. Es handelt sich um ein Verfahren zur Umstellung der Parametrierung eines parametrierbaren Schaltgeräts von einer Parametrierung unmittelbar am Schaltgerät auf eine Fernparametrierung, insbesondere über ein Kommunikationsnetz und/oder eine Datenleitung. Das Schaltgerät weist dabei ein oder mehrere Einstellelemente auf, mittels derer eine Einstellung von Parameterwerten unmittelbar am Schaltgerät erfolgen kann. Das Verfahren umfasst einen ersten Verfahrensschritt, in dem eine Kommunikationsverbindung zwischen einem Kommunikationsmodul zur Fernparametrierung und dem Schaltgerät hergestellt wird, wobei das Kommunikationsmodul so am Schaltgerät befestigt ist, dass das Kommunikationsmodul eines oder mehrere der Einstellelemente des Schaltgerätes abdeckt. Durch den Aufbau der Kommunikationsverbindung wird dem Schaltgerät signalisiert, dass für diejenigen Parameter, deren Einstellelemente von dem Kommunikationsmodul abgedeckt werden, nun nicht mehr die an den Einstellelementen eingestellten Parameterwerte zu verwenden sind, sondern die Parameterwerte, die von dem Kommunikationsmodul empfangen werden. Es ist möglich, dass die Definition, welche Einstellelemente von dem Kommunikationsmodul abgedeckt werden, von dem Kommunikationsmodul an das Schaltgerät übertragen wird. So können einem Schaltgerät zwei oder mehr unterschiedliche Kommunikationsmodule zugeordnet sein, die jeweils unterschiedliche Einstellelemente des Schaltgeräts abdecken und daher auch unterschiedliche Definitionen, welche Einstellelemente von dem Kommunikationsmodul abgedeckt werden, enthalten. Zur dauerhaften Speicherung der Definition kann ein dem Kommunikationsmodul zugehöriger Datensatz, der diese Definition enthält, in einem nicht-flüchtigen elektronischen Speicherbaustein des Kommunikationsmodul, z. B. einem EEPROM (= Electrically Erasable Programmable Read Only Memory), gespeichert sein. Und das Verfahren umfasst einen weiteren Verfahrensschritt, in dem Parameterwerte, die den abgedeckten Einstellelementen zugeordnet sind, von dem Kommunikationsmodul über die Kommunikationsverbindung an das Schaltgerät übertragen werden.

Der Erfindung liegt die Erkenntnis zugrunde, dass eine Bedienung eines Einstellelements des Schaltgeräts am besten durch ein physisches Abdecken des Einstellelements ausgeschlossen werden kann. Durch die positionstreue Befestigung des Kommunikationsmoduls am Schaltgerät ergibt sich eine Abdeckung von definierten Einstellelementen durch Gehäuseteile des Kommunikationsmoduls. Da diese Abdeckung erfindungsgemäß durch ein Kommunikationsmodul erfolgt, welches für eine Fernparametrierung des Schaltgeräts vorgesehen ist, wird dem Anwender eindeutig signalisiert, dass der dem abgedeckten Einstellelement zugeordnete Parameter nicht unmittelbar am Gerät einstellbar ist, sondern nur aus der Ferne, z. B. über ein Kommunikationsnetz oder eine zusätzliche Eingabeeinheit. Für den Anwender wird somit ein zweideutiger Zustand, in dem ihm unklar ist, auf welche Weise der Parameter eingestellt wird bzw. welcher Parameterwert im Betrieb des Schaltgeräts verwendet wird, vermieden.

Durch die Erfindung ist es möglich, Schaltgeräte zu realisieren, die als "Stand-alone"-Geräte ohne Kommunikationsanbindung über einfache Einstellelemente, auf Basis von Potentiometern und Drehcodierschaltern, parametrierbar sind, wobei die gewählte Parametrierung an Skalenanzeigen der Einstellelemente ablesbar ist, und mit der Erweiterung mit einem zusätzlich anbaubaren Kommunikationsmodul eine umfangreiche Parametrierung möglich wird, ohne dass dabei Parametereinstellungen an sichtbaren Einstellelementen Unklarheit über die intern verwendeten Parameter verursachen.

Vorteilhafte Ausgestaltungen und Weiterbildungen der Erfindung sind in den abhängigen Ansprüchen angegeben.

Laut der Erfindung weist das Kommunikationsmodul einen Sender auf. Der Sender dient in einer Kommunikationsverbindung zwischen dem Kommunikationsmodul und dem Schaltgerät dazu, über die Kommunikationsverbindung Parameterwerte an einen Empfänger des Schaltgeräts zu übertragen. Es können über die Kommunikationsverbindung Parameterwerte für diejenigen Parameter übertragen, die den abgedeckten Einstellelementen zugeordnet sind. Durch die Kommunikationsverbindung entsteht eine optische, elektrische oder elektromagnetische Verbindung zwischen dem als Grundgerät ausgestalteten Schaltgerät und dem als Erweiterungseinheit ausgestalteten Kommunikationsmodul, die es ermöglicht, Daten von der Erweiterungseinheit zu dem Grundgerät zu übertragen. Insbesondere kann die Kommunikationsverbindung als eine optische Verbindung mit oder ohne Lichtleiter oder als eine drahtlose Verbindung ausgebildet sein, die eine Potentialtrennung zwischen dem Grundgerät und dem Erweiterungsmodul ermöglicht. Für eine drahtlose Kommunikationsverbindung, die ohne elektrische leitungsgebundene Verbindung auskommt, können z. B. folgende Übertragungstechniken verwendet werden: Infrarot, Bluetooth, NFC (= Near Field Communication). Mit einer drahtlosen Kommunikationsverbindung ist es einfach möglich, zwischen dem oder den Stromkreisen des Grundgeräts und dem Stromkreis des Erweiterungsmoduls eine sichere galvanische Trennung zu realisieren.

Gemäß einer bevorzugten Weiterbildung der Erfindung weisen sowohl das Kommunikationsmodul als auch das Schaltgerät jeweils einen Sender und einen Empfänger auf. Dies ermöglicht einen bidirektionalen Datenaustausch zwischen dem als Grundgerät dienenden Schaltgerät und dem als Erweiterungsmodul dienenden Kommunikationsmodul. Damit können Datensätze in beiden Richtungen ausgetauscht werden; somit können z. B. Diagnosedaten und Messdaten aus dem Schaltgerät ausgelesen und über das Kommunikationsmodul und eine Kommunikationsverbindung zu einer auswertenden Stelle transportiert werden. Dabei können der Sender und der Empfänger als Transceiver, z. B. als Sende- und Empfangsdioden, ausgebildet sein.

Gemäß einer bevorzugten Weiterbildung der Erfindung ist das Kommunikationsmodul so ausgestaltet und die Position des Kommunikationsmoduls am Schaltgerät so gewählt, dass das in einer vorgegebenen Position relativ zum Schaltgerät befestigte Kommunikationsmodul Einstellelemente für ATEX-relevante Parameter zugänglich lässt, d. h. für Parameter, welche relevant für den Explosionsschutz sind (ATEX = ATEX-Richtlinien der Europäischen Union; Die Bezeichnung ATEX leitet sich aus der französischen Abkürzung für ATmosphères EXplosibles ab). Das Kommunikationsmodul wird also in einer Weise am Schaltgerät angebracht, dass nicht alle der am Schaltgerät vorhandenen Einstellelemente abgedeckt und somit unzugänglich gemacht werden: es werden diejenigen Einstellelemente nicht abgedeckt und somit zugänglich gehalten, welche ATEX-relevante Parameter betreffen, z. B. den Bemessungsbetriebsstrom oder Nennstrom Ie und die Auslöseklasse für den Motorüberlastschutz. Diese ATEX-relevanten Parameter bleiben ausschließlich mit den am Schaltgerät vorhandenen Einstellelementen parametrierbar, wohingegen andere Parameter, deren Einstellelemente abgedeckt sind, nur noch über das Kommunikationsmodul parametrierbar sind. Bei ATEX-relevanten Parametern ist bei einer Umstellung der Parametrierung eines parametrierbaren Schaltgeräts von einer Parametrierung unmittelbar am Schaltgerät auf eine Fernparametrierung, d. h. eine Parametrierung über ein Kommunikationsmodul, ein hoher Aufwand erforderlich, um sicherzustellen, dass diese Parameter ohne Fehler im Schaltgerät empfangen werden. Insofern ist es bei ATEX-relevanten Parametern vorteilhaft, diese nur über am Schaltgerät befindliche Einstellelemente verändern zu können.

Gemäß einer bevorzugten Weiterbildung der Erfindung weist das Kommunikationsmodul mindestens eine Buchse als Teil einer Kommunikationsschnittstelle zur Verbindung mit einem Kommunikationsnetz auf. Es ist auch möglich, dass das Kommunikationsmodul zwei Buchsen als Teile von Kommunikationsschnittstellen aufweist: Dabei kann die erste Buchse zur Kommunikationsverbindung mit einem Kommunikationsnetz und die zweite Buchse zur Kommunikationsverbindung mit einem weiteren Kommunikationsmodul genutzt wird; es ist auch möglich, dass die erste Buchse zur Kommunikationsverbindung mit einem ersten weiteren Kommunikationsmodul und die zweite Buchse zur Kommunikationsverbindung mit einem zweiten weiteren Kommunikationsmodul genutzt wird. Auf diese Weise können zwei oder mehr Kommunikationsmodul in Reihe geschaltet werden. Dabei ist es möglich, dass nur ein erstes Kommunikationsmodul der zwei oder mehr in Reihe geschalteten Kommunikationsmodule mit einem Kommunikationsnetz verbunden ist und der gesamte Datenverkehr zwischen dem Kommunikationsnetz und den zwei oder mehr in Reihe geschalteten Kommunikationsmodulen über das erste Kommunikationsmodul erfolgt; auf diese Weise fungiert das erste Kommunikationsmodul für alle Kommunikationsmodule der zwei oder mehr in Reihe geschalteten Kommunikationsmodule als gemeinsame Kommunikationsschnittstelle zu dem Kommunikationsnetz.

Gemäß einer bevorzugten Weiterbildung der Erfindung weist das Schaltgerät einen Empfänger für eine Kommunikationsverbindung zwischen dem Kommunikationsmodul und dem Schaltgerät auf, wobei der Empfänger über die Kommunikationsverbindung den abgedeckten Einstellelementen zugeordnete Parameterwerte vom Kommunikationsmodul empfangen kann. Dabei kommuniziert der Empfänger des Schaltgeräts mit dem Sender des Kommunikationsmoduls.

Eine Ausgestaltung der Erfindung wird gebildet durch eine Kombination von einem Schaltgerät, wie oben beschrieben, und einem an dem Schaltgerät befestigten Kommunikationsmodul, wie oben beschrieben. Dabei korrespondieren die Befestigungselemente des Schaltgeräts und die Befestigungselemente des Kommunikationsmoduls so, dass das Kommunikationsmodul nur in einer definierten Position am Schaltgerät befestigt werden kann; die Gehäuseteile des Kommunikationsmoduls bedecken in dieser Position nur vorgegebene Einstellelemente des Schaltgeräts.

Die skizzierte Aufgabenstellung wird auch durch ein erfindungsgemäßes Verfahren gelöst. Es handelt sich um ein Verfahren zur Umstellung der Parametrierung eines parametrierbaren Schaltgeräts. Ein Computerprogrammprodukt kann in einem Prozessor des Schaltgeräts ausführbar ausgebildet. Das Computerprogrammprodukt kann als Software, z. B. als eine herunterladbare Applikations-Software (kurz: App), oder als Firmware in einem Speicher des Kommunikationsmoduls speicherbar und durch den Prozessor oder ein Rechenwerk des Schaltgeräts ausführbar ausgebildet sein. Alternativ oder ergänzend können ein oder mehrere Funktionen des Computerprogrammprodukts in Hardware ausgebildet sein, beispielsweise als ein ASIC oder in Form einer programmierbaren Logikschaltung, z. B. eines FPGA (ASIC = Application-Specific Integrated Circuit; FPGA = Field Programmable Gate Array). Das erfindungsgemäße Computerprogrammprodukt ist dazu ausgebildet, das Verfahren nach einem der oben erwähnten Ansprüche durchzuführen. Das Computerprogrammprodukt ist also dazu ausgebildet, das Verfahren zur Umstellung der Parametrierung eines parametrierbaren Schaltgeräts durchzuführen. Insbesondere ist es dazu ausgebildet, den Schritt Herstellen einer Kommunikationsverbindung zwischen einem Kommunikationsmodul zur Fernparametrierung und dem Schaltgerät durchzuführen. Außerdem ist es dazu ausgebildet, den Schritt Übertragen von Parameterwerten, die abgedeckten Einstellelementen zugeordnet sind, von dem Kommunikationsmodul über die Kommunikationsverbindung an das Schaltgerät auszuführen. Das Computerprogrammprodukt kann dazu ausgebildet werden, mindestens das skizzierte Verfahren zur Umstellung der Parametrierung umzusetzen und durchzuführen. Dabei kann das Computerprogrammprodukt sämtliche Teilfunktionen des Verfahrens in sich vereinigen, also monolithisch ausgebildet sein. Alternativ kann das Computerprogrammprodukt auch segmentiert ausgebildet sein und jeweils Teilfunktionen auf Segmente verteilen, die auf separater Hardware ausgeführt werden. So kann das Computerprogrammprodukt teilweise in einem Prozessor des Schaltgeräts und teilweise in einem Prozessor des Kommunikationsmoduls ausführbar ausgebildet sein. Außerdem kann ein Teil des Verfahrens in dem Schaltgerät und/oder dem Kommunikationsmodul durchgeführt werden und ein anderer Teil des Verfahrens in einer dem Schaltgerät und/oder dem Kommunikationsmodul übergeordneten Steuereinheit, wie beispielsweise einer SPS, einem Handparametriergerät oder einer Computer-Cloud (SPS = Speicherprogrammierbare Steuerung).

Die oben beschriebenen Eigenschaften, Merkmale und Vorteile dieser Erfindung sowie die Art und Weise, wie diese erreicht werden, werden klarer und deutlicher verständlich durch die folgende Beschreibung der Zeichnungen. Hierbei zeigen in schematischer und nicht maßstabsgetreuer Darstellung:
- FIG 1: die Bedienseite eines Schaltgeräts;
- FIG 2: die Bedienseite des in FIG 1 gezeigten Schaltgeräts mit einem aufgesteckten Kommunikationsmodul gemäß einem Ausführungsbeispiel der vorliegenden Erfindung;
- FIG 3: den Schnitt III-III von FIG 2;
- FIG 4: eine Bedienseite des in FIG 1 gezeigten Schaltgeräts mit einem aufgesteckten Kommunikationsmodul gemäß einem weiteren Ausführungsbeispiel der vorliegenden Erfindung; und
- FIG 5: ein Ablaufdiagramm eines Verfahrens gemäß einem Ausführungsbeispiel der vorliegenden Erfindung.

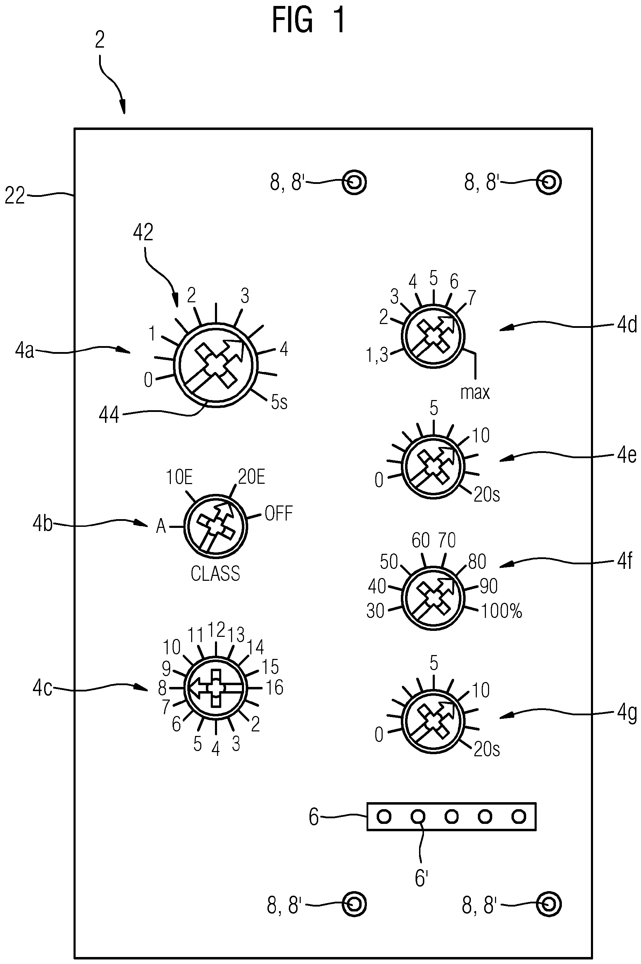

FIG 1 zeigt die Bedienseite eines Gehäuses 22 eines Schaltgeräts 2. Es weist sieben zur Einstellung von Parametern vorgesehene Einstellelemente 4a bis 4g auf, die jeweils einen Drehknopf 44 mit einer Pfeilmarkierung und eine um den Drehknopf 44 herum angeordnete Skalenanzeige 42 aufweisen. Dabei sind die Einstellelemente 4a bis 4g in zwei Spalten angeordnet. In der linken Spalte ist ein Einstellelement 4a für die Losbrechzeit, ein Einstellelement 4b für die CLASS-Einstellung für den Motorüberlastschutz und ein Einstellelement 4c für den Bemessungsbetriebsstrom. In der rechten Spalte ist ein Einstellelement 4d für die Strombegrenzung, ein Einstellelement 4e für die Startspannung, ein Einstellelement 4f für die Anlauframpenzeit und ein Einstellelement 4g für die Auslaufzeit.

Darüber hinaus sind auf der Bedienseite vier als Sacklöcher ausgebildete Befestigungselemente 8` als Befestigungsvorrichtung 8 für ein Kommunikationsmodul vorgesehen, sowie eine Lochreihe mit Durchgangsöffnungen 6` im Gehäuse 22 auf, die als eine Kommunikationsschnittstelle 6 für ein Kommunikationsmodul vorgesehen ist.

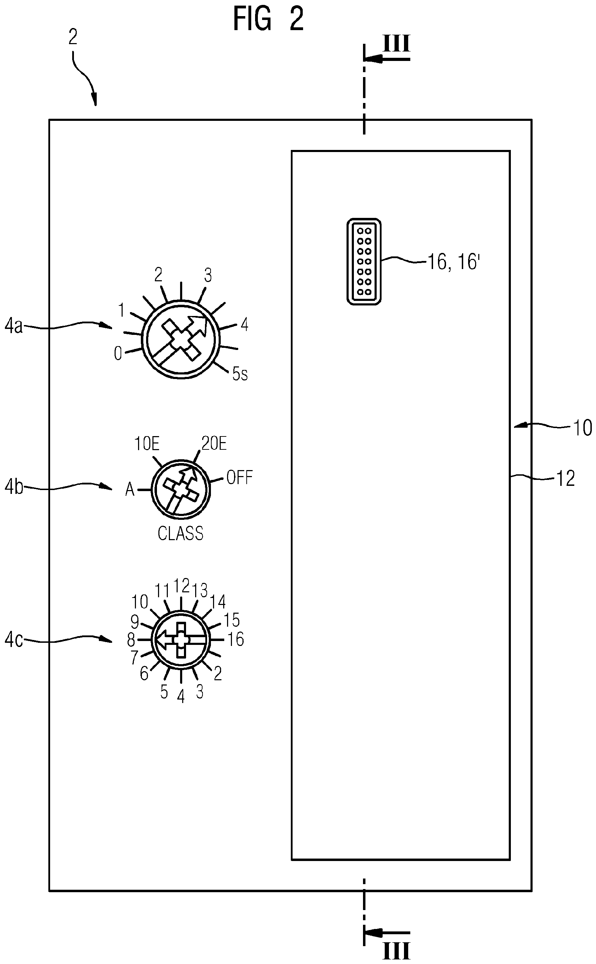

FIG 2 zeigt die Bedienseite des in FIG 1 gezeigten Schaltgeräts 2 mit einem aufgesteckten Kommunikationsmodul 10. Zur Fixierung ist das Kommunikationsmodul 10 mit an einem Gehäuse 12 des Kommunikationsmoduls 10 angeordneten Befestigungselementen in Form von Stiften in die in FIG 1 gezeigten Sacklöcher 8' des Gehäuses 22 des Schaltgeräts 2 eingesteckt worden. Das Gehäuse 12 des Kommunikationsmoduls 10 deckt alle vier Einstellelemente 4d bis 4g der rechten Spalte ab, lässt aber die drei Einstellelemente 4a bis 4c der linken Spalte zur Bedienung zugänglich. Das Kommunikationsmodul 10 weist auf seiner dem Bediener zugewandten Seite eine Buchse 16' als Teil einer Kommunikationsschnittstelle 16 zur Verbindung mit einem Kommunikationsnetz auf.

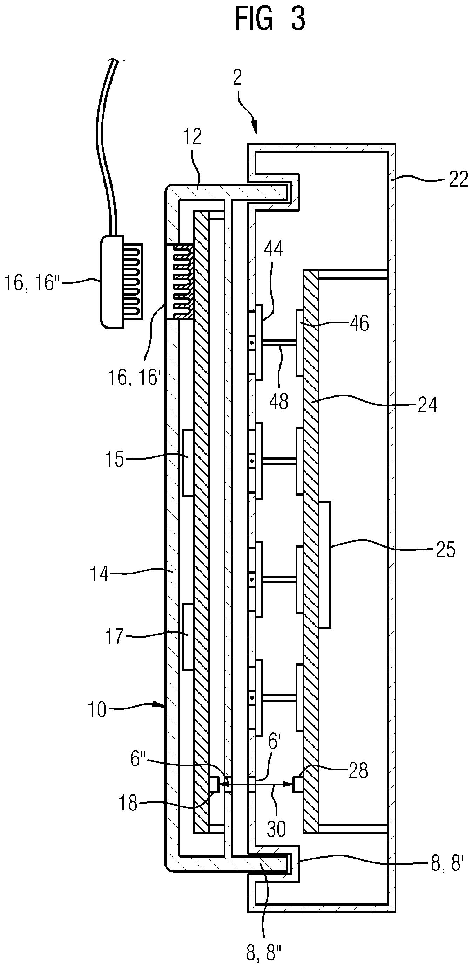

FIG 3 zeigt den Schnitt entlang der in FIG 2 angegebenen Schnittebene III-III. Das Kommunikationsmodul 10 ist an dem Schaltgerät 2 befestigt. Dazu weist das Gehäuse 12 des Kommunikationsmoduls 10 an seiner Unterseite, d. h. an seiner dem Schaltgerät 2 zugewandten Seite, senkrecht abstehende Stifte 8" als Befestigungselemente auf, die in die als Befestigungselemente dienenden Sacklöcher 8' des Gehäuses 22 des Schaltgeräts 2 eingesteckt worden sind. Auf diese Weise dienen die Stifte 8" und die Sacklöcher 8` als eine Befestigungsvorrichtung 8 zur positionstreuen Befestigung des Kommunikationsmoduls 10 an dem Schaltgerät 2.

Das Schaltgerät 2 weist im Inneren seines Gehäuses 22 eine Flachbaugruppe 24 (engl.: PCB = Printed Circuit Board) auf, welche Potentiometer und Drehcodierschalter 46 trägt, die über eine Wirkverbindung 48 durch die Einstellelemente 4a bis 4g verstellt werden können, um Parameter zum Betrieb des Schaltgeräts 2 einzustellen.

Das Kommunikationsmodul 10 weist im Inneren seines Gehäuses 12 eine Flachbaugruppe 14 auf, welche eine Buchse 16' als Teil einer Kommunikationsschnittstelle 16 zur Verbindung mit einem Kommunikationsnetz mittels eines in die Buchse 16` einsteckbaren Netzwerk-Steckers 16" und eine als Sender dienende LED 18 trägt. Die Sender-LED 18 des Kommunikationsmoduls 10 ist durch korrespondierende Öffnungen 6', 6" in den Gehäusen 12, 22 des Kommunikationsmoduls 10 und des Schaltgeräts 2 in optischem Kontakt mit einer als Empfänger dienenden Fotodiode 28, welche auf der Flachbaugruppe 24 des Schaltgeräts 2 angeordnet ist. Auf diese Weise existiert zwischen dem Kommunikationsmodul 10 und dem Schaltgerät 2 eine Kommunikationsverbindung, über die Parameterwerte für diejenigen Parameter, die den abgedeckten Einstellelementen zugeordnet sind, von dem Kommunikationsmodul 10 zu dem Schaltgerät übertragbar sind.

Es ist auch möglich, dass sowohl das Kommunikationsmodul 10 als auch das Schaltgerät 2 jeweils einen Sender und einen Empfänger aufweisen. Die ermöglicht einen bidirektionalen Datenaustausch zwischen dem als Grundgerät dienenden Schaltgerät 2 und dem als Erweiterungsmodul dienenden Kommunikationsmodul 10, d. h. eine bidirektional ausgeprägte Kommunikationsverbindung.

In einer alternativen Ausgestaltung kann durch die korrespondierende Öffnungen 6', 6" auch eine mehrpolige elektrische Kontaktierung, z. B. mithilfe von elektrisch leitenden Federelementen, zwischen der Flachbaugruppe 14 des Kommunikationsmoduls 10 und der Flachbaugruppe 24 des Schaltgeräts 2 hergestellt werden.

Das Kommunikationsmodul 10 weist auf seiner Flachbaugruppe 14 außerdem einen Speicher 15 und einen Prozessor 17 auf. In dem Speicher 15, der als ein nicht-flüchtiger elektronischer Speicherbaustein, z. B. als ein EEPROM, ausgebildet ist, ist ein Computerprogrammprodukt zur Umstellung der Parametrierung eines parametrierbaren Schaltgeräts gespeichert, wobei das Computerprogrammprodukt in einem Prozessor 25 des Schaltgeräts 2 ausführbar und zur Durchführung des erfindungsgemäßen Verfahrens ausgebildet ist. Das Auslesen des Computerprogrammprodukts aus dem Speicher 15 und die Übertragung des Computerprogrammprodukts über die Kommunikationsverbindung 30 zu dem Schaltgerät 2 wird durch den Prozessor 17 des Kommunikationsmoduls 10 gesteuert. Im Schaltgerät 2 wird das empfangene Computerprogrammprodukt in einem auf der Flachbaugruppe 24 des Schaltgeräts 2 angeordneten Prozessor 25 ausgeführt.

Es ist möglich, dass durch das Aufstecken des Kommunikationsmoduls 10 auf das Schaltgerät 2, z. B. durch das Einführen eines Stifts 8" in ein Sackloch 8', ein elektrischer Kontakt hergestellt wird, der die Prozessoren 15, 25 von Grundgerät 2 und Erweiterungsmodul 10 triggert, mithilfe von Sender 18 und Empfänger 28 die Kommunikationsverbindung 30 aufzubauen. Durch den Aufbau der Kommunikationsverbindung 30 wird dem Schaltgerät 2 signalisiert, dass für diejenigen Parameter, deren Einstellelemente 4d - 4g von dem Kommunikationsmodul 10 abgedeckt werden, nun nicht mehr die an den Einstellelementen 4d - 4g eingestellten Parameterwerte zu verwenden sind, sondern die Parameterwerte, die das Schaltgerät 2 von dem Kommunikationsmodul 10 empfängt. Außer dem Computerprogrammprodukt zur Umstellung der Parametrierung ist auch die Information, welche der Einstellelemente 4a - 4g des Schaltgeräts 2 von dem Kommunikationsmodul 10 abgedeckt werden, in dem Speicher 15 des Kommunikationsmoduls 10 enthalten. Die Definition, welche Einstellelemente 4d - 4g von dem Kommunikationsmodul 10 abgedeckt werden, wird von dem Kommunikationsmodul 10 an das Schaltgerät 2 übertragen, wo sie zur durch den Prozessor 25 des Schaltgeräts 2 durchgeführten Steuerung verwendet wird, ob für einen bestimmten Parameter ein an einem Einstellelement 4a - 4g des Schaltgeräts 2 eingestellte Parameterwert oder ein von dem Kommunikationsmodul 10 erhaltener Parameterwert im Betrieb des Schaltgeräts Verwendung finden soll.

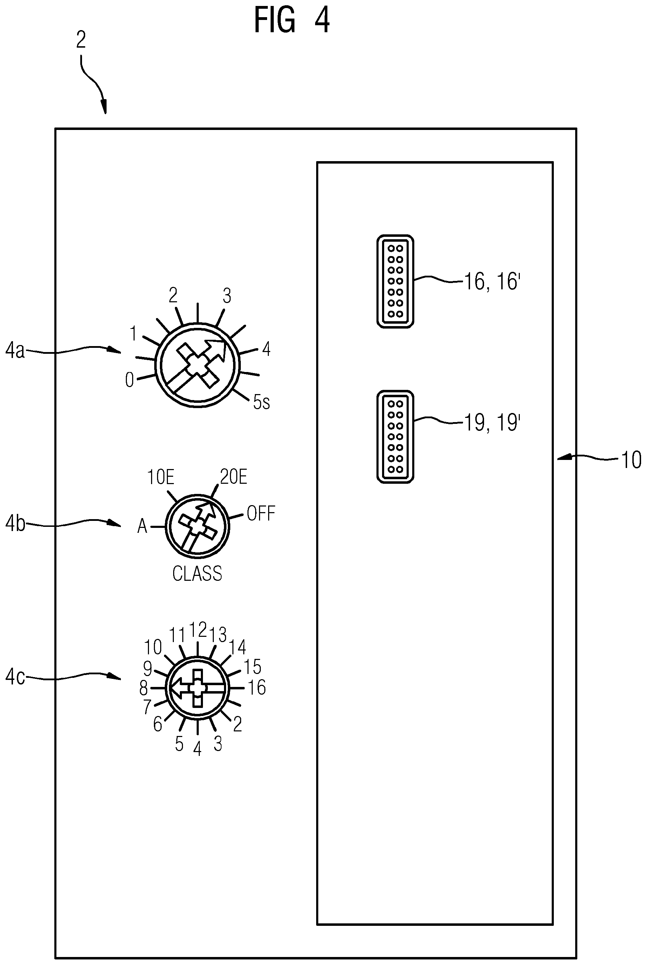

FIG 4 zeigt die Bedienseite des in FIG 1 gezeigten Schaltgeräts 2 mit einem alternativen aufgesteckten Kommunikationsmodul 10, welches gegenüber dem in FIG 2 gezeigten Kommunikationsmodul 10 folgenden Unterschied aufweist: Zusätzlich zu der Buchse 16' als Teil einer ersten Kommunikationsschnittstelle 16 zur Verbindung mit einem Kommunikationsnetz, welche das in FIG 2 gezeigte Kommunikationsmodul 10 auf seiner Bedienseite trägt, weist das in FIG 4 gezeigte Kommunikationsmodul 10 eine weitere Buchse 19` als Teil einer zweiten Kommunikationsschnittstelle 19 zur Verbindung mit einem weiteren, nicht dargestellten Kommunikationsmodul auf, welches seinerseits ebenfalls auf ein Schaltgerät aufgesteckt ist. Auf diese Weise können zwei oder mehr Kommunikationsmodule in Reihe geschaltet werden. Dabei ist es möglich, dass nur ein erstes Kommunikationsmodul der zwei oder mehr in Reihe geschalteten Kommunikationsmodule mit einem Kommunikationsnetz verbunden ist und der gesamte Datenverkehr zwischen dem Kommunikationsnetz und den zwei oder mehr in Reihe geschalteten Kommunikationsmodulen über das erste Kommunikationsmodul erfolgt; auf diese Weise fungiert das erste Kommunikationsmodul für alle Kommunikationsmodule der zwei oder mehr in Reihe geschalteten Kommunikationsmodule als gemeinsame Kommunikationsschnittstelle zu dem Kommunikationsnetz.

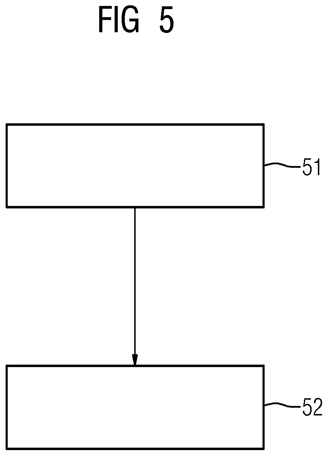

FIG 5 zeigt ein Ablaufdiagramm des beanspruchten Verfahrens zur Umstellung der Parametrierung eines parametrierbaren Schaltgeräts von einer Parametrierung unmittelbar am Schaltgerät auf eine Fernparametrierung, insbesondere über ein Kommunikationsnetz und/oder eine Datenleitung. Das Verfahren umfasst einen ersten Verfahrensschritt 51, in dem ein Kommunikationsmodul, das zur Fernparametrierung geeignet ist, am Schaltgerät, welches ein oder mehrere Einstellelemente aufweist, mittels derer eine Einstellung von Parameterwerten unmittelbar am Schaltgerät erfolgen kann, so befestigt wird, dass das Kommunikationsmodul eines oder mehrere der Einstellelemente abdeckt. Das Verfahren umfasst einen weiteren Verfahrensschritt 52, in dem eine Kommunikationsverbindung zwischen dem Kommunikationsmodul und dem Schaltgerät hergestellt wird. Und das Verfahren umfasst einen weiteren Verfahrensschritt 53, in dem Parameterwerte, die den abgedeckten Einstellelementen zugeordnet sind, von dem Kommunikationsmodul über die Kommunikationsverbindung an das Schaltgerät übertragen werden.

## Patentansprüche

1. Kombination von einem Schaltgerät (2) und einem an dem Schaltgerät (2) befestigten Kommunikationsmodul (10),
wobei das Schaltgerät (2) ein oder mehrere Einstellelemente (4a - 4g) zum Einstellen von Parameterwerten des Schaltgeräts (2) aufweist und ein oder mehrere Befestigungselemente (8, 8') zur positionstreuen Befestigung des Kommunikationsmoduls (10) am Schaltgerät (2) aufweist, so, dass eines oder mehrere (4d - 4g) der Einstellelemente (4a - 4g) durch das Kommunikationsmodul (10) abgedeckt werden,
wobei das Kommunikationsmodul (10) ein oder mehrere Befestigungselemente (8, 8") zur positionstreuen Befestigung des Kommunikationsmoduls (10) am Schaltgerät (2) aufweist und Gehäuseteile (12) aufweist, die die ein oder mehreren Einstellelemente (4d - 4g) des Schaltgeräts (2) abdecken, wobei das Kommunikationsmodul (10) einen Sender (18) für eine Kommunikationsverbindung (30) zwischen dem Kommunikationsmodul (10) und dem Schaltgerät (2) aufweist, wobei der Sender (18) über die Kommunikationsverbindung (30) den abgedeckten Einstellelementen (4d - 4g) zugeordnete Parameterwerte an das Schaltgerät übertragen kann, und
wobei das Schaltgerät (2) einen Empfänger (28) für eine Kommunikationsverbindung (30) zwischen dem Kommunikationsmodul (10) und dem Schaltgerät (2) aufweist, wobei der Empfänger (28) über die Kommunikationsverbindung (30) den abgedeckten Einstellelementen (4d - 4g) zugeordnete Parameterwerte vom Kommunikationsmodul (10) empfangen kann.

2. Kombination nach Anspruch 1, wobei das Kommunikationsmodul (10) einen Sender (18) und einen Empfänger für eine bidirektionale Kommunikationsverbindung (30) zwischen dem Kommunikationsmodul (10) und dem Schaltgerät (2) aufweist.

3. Kombination nach einem der vorhergehenden Ansprüche, wobei das in einer vorgegebenen Position relativ zum Schaltgerät (2) befestigte Kommunikationsmodul (10) Einstellelemente (4b, 4c) für Parameter, welche relevant für den Explosionsschutz sind, zugänglich lässt.

4. Kombination nach einem der vorhergehenden Ansprüche, wobei das Schaltgerät (2) einen Sender und einen Empfänger (28) für eine bidirektionale Kommunikationsverbindung (30) zwischen dem Kommunikationsmodul (10) und dem Schaltgerät (2) aufweist.

5. Verfahren zur Umstellung der Parametrierung eines Schaltgeräts (2), welches ein oder mehrere Einstellelemente (4a - 4g) zum Einstellen von Parameterwerten des Schaltgeräts (2) aufweist, auf Fernparametrierung, mit folgenden Schritten:
- Herstellen einer Kommunikationsverbindung (30) zwischen einem Kommunikationsmodul (10) zur Fernparametrierung und dem Schaltgerät (2), wobei das Kommunikationsmodul (10) so am Schaltgerät (2) befestigt ist, dass das Kommunikationsmodul (10) eines oder mehrere (4d - 4g) der Einstellelemente (4a - 4g) abdeckt; und
- Übertragen von Parameterwerten, die den abgedeckten Einstellelementen (4d - 4g) zugeordnet sind, von dem Kommunikationsmodul (10) über die Kommunikationsverbindung (30) an das Schaltgerät (2).

## Claims

1. Combination of a switching device (2) and a communication module (10) mounted on the switching device (2), wherein the switching device (2) has one or more setting elements (4a - 4g) for setting parameter values of the switching device (2) and has one or more mounting elements (8, 8') for mounting the communication module (10) on the switching device (2) in a precisely defined position, such that one or more (4d - 4g) of the setting elements (4a - 4g) are covered by the communication module (10),
wherein the communication module (10) has one or more mounting elements (8, 8'') for mounting the communication module (10) on the switching device (2) at a precisely defined position and has housing parts (12) that cover the one or more setting elements (4d - 4g) of the switching device (2),
wherein the communication module (10) has a transmitter (18) for a communication connection (30) between the communication module (10) and the switching device (2),
wherein the transmitter (18) can use the communication connection (30) to transmit parameter values assigned to the covered setting elements (4d - 4g) to the switching device, and wherein the switching device (2) has a receiver (28) for a communication connection (30) between the communication module (10) and the switching device (2),
wherein the receiver (28) can use the communication connection (30) to receive parameter values assigned to the covered setting elements (4d - 4g) from the communication module (10).

2. Combination according to Claim 1, wherein the communication module (10) has a transmitter (18) and a receiver for a bidirectional communication connection (30) between the communication module (10) and the switching device (2).

3. Combination according to either of the preceding claims, wherein the communication module (10) mounted in a predefined position relative to the switching device (2) leaves setting elements (4b, 4c) accessible for parameters that are relevant to explosion protection.

4. Combination according to one of the preceding claims, wherein the switching device (2) has a transmitter and a receiver (28) for a bidirectional communication connection (30) between the communication module (10) and the switching device (2).

5. Method for converting the parameterization of a switching device (2), which has one or more setting elements (4a - 4g) for setting parameter values of the switching device (2), to remote parameterization, having the following steps:
- setting up a communication connection (30) between a communication module (10) for remote parameterization and the switching device (2), wherein the communication module (10) is mounted on the switching device (2) such that the communication module (10) covers one or more (4d - 4g) of the setting elements (4a - 4g); and
- transmitting parameter values which are assigned to the covered setting elements (4d - 4g) from the communication module (10) to the switching device (2) using the communication connection (30).

## Revendications

1. Combinaison d'un appareil (2) de coupure et d'un module (10) de communication fixé à l'appareil (2) de coupure, dans laquelle l'appareil (2) de coupure a un ou plusieurs éléments (4a - 4g) de réglage pour le réglage de valeurs de paramètre de l'appareil (2) de coupure et a un ou plusieurs éléments (8, 8') de fixation pour la fixation d'une manière fidèle en position du module (10) de communication sur l'appareil (2) de coupure, de manière à recouvrir un ou plusieurs (4d - 4g) de éléments (4a - 4g) de réglage par le module (10) de communication,
dans laquelle le module (10) de communication a un ou plusieurs éléments (8, 8") de fixation pour la fixation d'une manière fidèle en position du module (10) de communication sur l'appareil (2) de coupure et a des parties (12) de boîtier, qui recouvrent un ou plusieurs éléments (4d - 4g) de réglage de l'appareil (2) de coupure, dans laquelle l'appareil (10) de communication a un émetteur (18) pour une liaison (30) de communication entre le module (10) de communication et l'appareil (2) de coupure, dans laquelle l'émetteur (18) peut transmettre à l'appareil de coupure, par la liaison (30) de communication, des valeurs de paramètre affectées aux éléments (4d - 4g) de réglage recouverts et dans laquelle l'appareil (2) de coupure a un récepteur (28) pour une liaison (30) de communication entre le module (10) de communication et l'appareil (2) de coupure, dans laquelle le récepteur (28) peut, par la liaison (30) de communication, recevoir du module (10) de communication des valeurs de paramètre affectées aux éléments (4d - 4g) de réglage recouverts.

2. Combinaison suivant la revendication 1, dans laquelle le module (10) de communication a un émetteur (18) et un récepteur pour une liaison (30) bidirectionnelle entre le module (10) de communication et l'appareil (2) de coupure.

3. Combinaison suivant l'une des revendications précédentes, dans laquelle le module (10) de communication, fixé dans une position donnée à l'avance par rapport à l'appareil (2) de coupure, donne accès à des éléments (4b - 4c) de réglage de paramètres, qui sont pertinents pour la protection vis-à-vis d'une explosion.

4. Combinaison suivant l'une des revendications précédentes, dans laquelle l'appareil (2) de coupure a un émetteur et un récepteur (28) pour une liaison (30) de communication bidirectionnelle entre le module (10) de communication et l'appareil (2) de coupure.

5. Procédé pour le passage du paramétrage d'un appareil (2) de coupure, qui a un ou plusieurs éléments (4a - 4g) de réglage pour le réglage de valeurs de paramètre de l'appareil (2) de coupure à un téléparamétrage, comprenant les stades suivants :
- établissement d'une liaison (30) de communication entre un module (10) de communication pour le téléparamétrage et l'appareil (2) de coupure, dans lequel le module (10) de communication est fixé à l'appareil (2) de coupure, de manière à ce que le module (10) de communication recouvre un ou plusieurs (4d - 4g) des éléments (4a- 4g) de réglage ; et
- transmission des valeurs de paramètre, qui sont affectées aux éléments (4d - 4g) de réglage recouverts du module (10) de communication, à l'appareil (2) de coupure par la liaison (30) de communication.
